Europäisches Patentamt

European Patent Office

Office européen des brevets

(11) Publication number: **0 379 321**
**A2**

(12) # EUROPEAN PATENT APPLICATION

(21) Application number: **90300399.4**

(22) Date of filing: **15.01.90**

(51) Int. Cl.5: **G01R 25/00**

(30) Priority: **18.01.89 GB 8901054**

(43) Date of publication of application:
**25.07.90 Bulletin  90/30**

(84) Designated Contracting States:
**AT BE CH DE DK ES FR GB GR IT LI LU NL SE**

(71) Applicant: **THORN EMI Electronics Limited**
**Blyth Road**
**Hayes Middlesex UB3 1DL(GB)**

(72) Inventor: **Bream, David Robert**
**Flat 12, 15, Bawtree Road**
**Uxbridge, Middlesex B8 1PT(GB)**
Inventor: **Roome, Stephen John**
**41, Bentinck Road**
**West Dryton, Middlesex UB7 7RG(GB)**

(74) Representative: **Fleming, Ian Alexander et al**
**THORN EMI Patents Limited The Quadrangle**
**Westmount Centre Uxbridge Road**
**Hayes Middlesex, UB4 0HB(GB)**

(54) **Phase difference measurement.**

(57) Apparatus for measuring the phase difference between input signals $X_1$ and $X_2$ of equal frequency comprises quadrature sampling circuits, such as Digital Radio Frequency Memories (DRFMs) 1 and 3, having a common local oscillator 13. Analogue to digital converters 29,31,33,35, having a common sampling clock 37, are provided for digitising the in-phase and quadrature samples. The digitised samples are used in look up tables 39 and 41 to provide values of instantaneous phase which, preferably using modular arithmetic, are used to derive in an arithmetic circuit a number of values of phase difference between the signals $X_1$ and $X_2$.

The mean of the number of values of phase difference is then determined by the use of an accumulator circuit operating in conjunction with a divider circuit which is clocked at a sub multiple of the sampling clock 37.

In an alternative embodiment for higher speed operation, the analogue to digital converters 29,31,33,35 and look up tables 39 and 41 may be substituted by comparators arranged to detect the polarity of the samples and to provide a binary 1 or 0 to indicate the phase of the samples.

Fio.1

## PHASE DIFFERENCE MEASUREMENT

This invention relates to the measurement of the phase difference between two signals of equal frequency. Such a measurement is required in a number of circumstances, for example in the determination of the angle of arrival of a radar signal by the measurement of the phase difference between the signals from two adjacent elements of a phased array antenna.

In U.S. Patent No. 4,743,905 there is described a system for measuring the phase difference between two signals of equal frequency in which the two signals are quadrature sampled using a Digital Radio Frequency Memory to produce respective signals each comprising a series of digital instantaneous phase values, these signals then being stored. The two digitised phase signals are then transformed from the time domain to the frequency domain, the centre frequency determined, and the phase difference between the centre frequencies of the frequency domain signals calculated. Such a method suffers the disadvantage however that it is relatively complex and furthermore requires a relatively long sampling of the two input signals thus preventing real time estimates of the phase difference being obtained.

It is an object of the present invention to provide a method of difference measurement, together with apparatus for implementing such a method, wherein these disadvantages are at least alleviated.

According to a first aspect of the present invention a method for measuring the phase difference between a plurality of signals of equal frequency comprises: quadrature sampling the signals using a plurality of quadrature sampling circuits, having a common local oscillator, so as to provide values of instantaneous phase in respect of each signal; deriving from the values of instantaneous phase a plurality of values of phase difference between at least a first and a further of the signals; and obtaining the mean value of the plurality of values of phase difference.

In one particular method in accordance with the invention, the plurality of values of phase difference are derived using modular arithmetic.

According to a second aspect of the invention, an apparatus for measuring the phase difference between at least two signals of equal frequency comprises: a plurality of quadrature sampling circuits having a common local oscillator for providing from signals input thereto values of instantaneous phase in respect of each input signal; and an arithmetic circuit for deriving from the instantaneous values of phase a plurality of phase difference values between at least a first and a further of the input signals; and an averaging circuit for obtaining the mean value of the plurality of phase difference values.

In one particular apparatus in accordance with the invention the quadrature sampling circuits comprise Digital Radio Frequency Memories. The arithmetic circuit for deriving a number of values of phase difference is suitably a modular arithmetic means. The averaging circuit for obtaining the mean value suitably comprises an accumulator means for accumulating the sum of the values of phase difference, and a divider means which is effective, to produce said mean value only when required.

One phase difference measurement apparatus in accordance with the invention, together with its mode of operation will now be described, by way of example only, with reference to the accompanying drawings in which:

Figure 1 is a schematic representation of a quadrature sampling system for obtaining digital values of the instantaneous phases $\emptyset_1(t)$, $\emptyset_2(t)$ of two input signals;

Figure 2 is a graphical representation of the measured phase values $\emptyset_1(i)$, $\emptyset_2(i)$;

Figure 3 is a schematic representation of the system for obtaining the required phase difference measurement from the measured phase values $\emptyset_1 - (i)$, $\emptyset_2(i)$; and

Figure 4 is a schematic representation of an alternative quadrature sampling system for obtaining a binary value indicative of the instantaneous phases $\emptyset_1(t)$, $\emptyset_2(t)$, of two input signals.

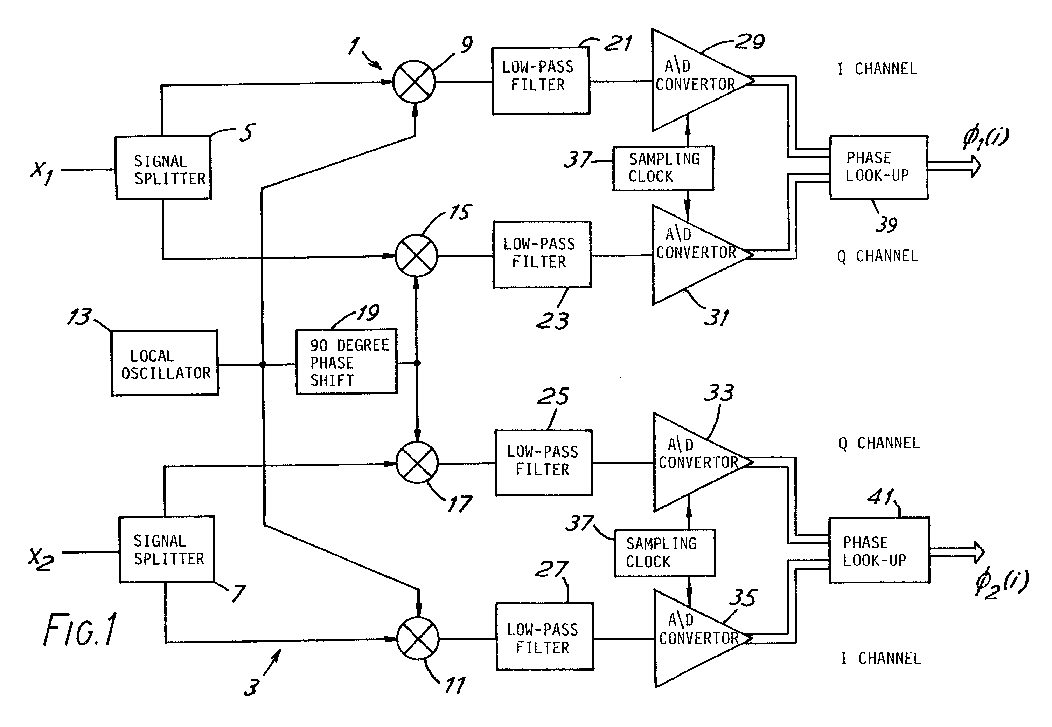

Referring firstly to Figure 1, the apparatus to be described is a high precision system using two high speed quadrature sampling systems 1, 3 i.e. Digital Radio Frequency Memories (DRFMs). DRFMs and their operation will be assumed to be known by persons familiar with this art and will not therefore be described further in the context of the present invention. Such devices and their operation are described in detail in GB 1605203, the contents of which are specifically incorporated herein by reference. Each DRFM 1 or 3 is arranged to obtain digital values of the instantaneous phase $\emptyset_1(t)$ or $\emptyset_2(t)$ measured at any particular time t of one of two equal frequency input signals $X_1$ and $X_2$ whose phase difference it is required to determine. The input signals $X_1$, $X_2$ are each split equally between two channels by respective signal splitters 5, 7 within the two DRFMs 1, 3. The split signals in the first channel of each DRFM 1, 3, the 'inphase' or I channels, are mixed at respective mixers 9, 11 with a sinusoidal signal from a local oscillator 13 common to the two DRFMs 1, 3. The split signals in the second channel of each DRFM, the 'quadrature' or Q channels, are mixed at respective mixers 15, 17 by the same local oscillator signal after it has been phase shifted by 90 degrees at a phase shifter 19. The resultant signals in each pair of I and Q channels are then filtered by respective pairs of low-pass filters 21, 23 and 25, 27 to remove the upper sideband produced by the mixing process, and digitised by respective pairs of analogue/digital converters 29, 31 and 33, 35. The four channels are matched such that the digitisation in all four channels occurs simultaneously, the four analogue/digital converters 29, 31, 33, 35 all being clocked by a common sampling clock 37.

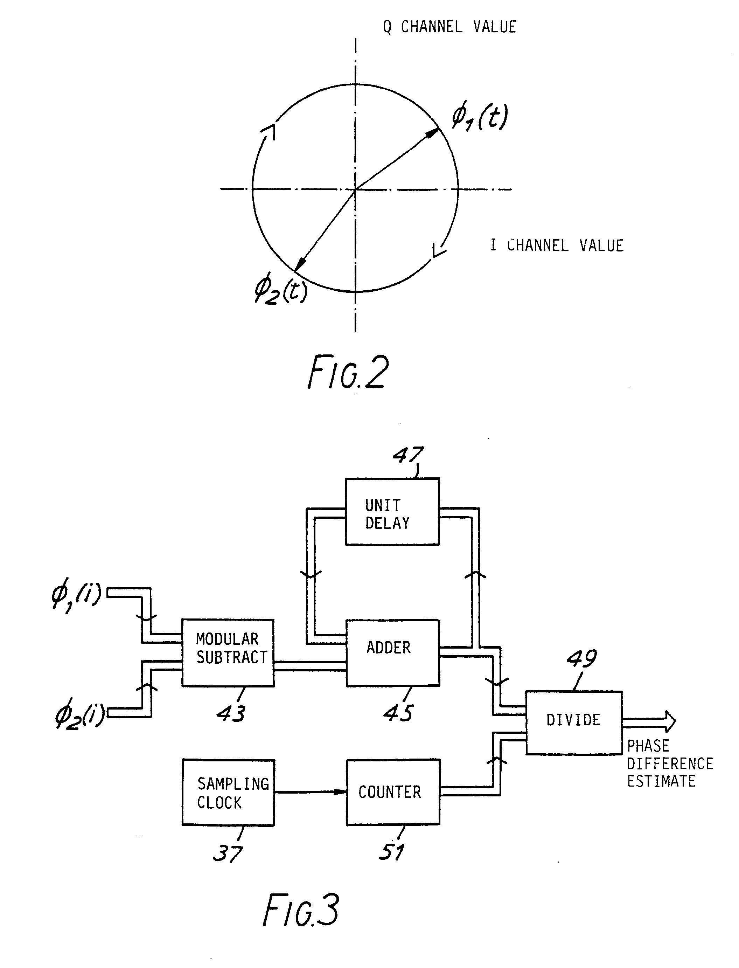

Referring now also to Figure 2, the resultant digital numbers in each channel describe the I and Q components of a signal of carrier frequency equal to the difference between the signal generated by the local oscillator 13 and the frequency of the input signals $X_1$ and $X_2$, where the input signals are sinusoidal, or the carrier frequency of the input signals where the input signals are modulated sinusoids. The phases $\emptyset_1(t)$ and $\emptyset_2(t)$ of the signals may be represented graphically, as illustrated in Figure 2, as vectors rotating in a circle. The amplitudes of the signals are given by the magnitudes of these vectors, whilst the phases $\emptyset_1(t)$ and $\emptyset_2(t)$ are equal to the arc tangent of the ratio of the signals in the respective Q and I channels. In the particular apparatus being described, however, the values of $\emptyset_1(n)$ and $\emptyset_2(n)$ are derived from the I and Q digital numbers using look-up tables 39, 41.

A set of values of $\emptyset_1(i)$ and $\emptyset_2(i)$ are thus produced by the DRFMs 1, 3 where i defines equal time intervals 0, 1, 2, 3 ----- (N-1), N being the number of samples taken.

The required phase difference calculation is carried out by the arithmetic circuit and averaging circuit shown in Figure 3. The values of $\emptyset_1(i)$ and $\emptyset_2(i)$ are sequentially input into an arithmetic circuit, such as a modular subtract unit 43, which is arranged to give a value of phase difference $\emptyset_1(i) - \emptyset_2(i)$ between minus 180 degrees and plus 180 degrees using modular arithmetic. In order to simplify the procedure the assumption is made that the phase difference between successive phase measurements takes place in the same direction for each pair of values $\emptyset_1(i)$ and $\emptyset_2(i)$, i.e. clockwise as shown in the graphical representation of Figure 2, or alternatively anticlockwise.

The output of the modular subtract unit 43 is fed into an averaging or accumulator circuit comprising an adder 45 and a unit delay 47 arranged in a feedback loop to produce a value of the quantity

$$\sum_{i-0}^{N-1} \left[ \emptyset_1(i) - \emptyset_2(i) \right]$$

This value is fed into a divide circuit 49 together with a value of N produced by a counter 51 addressed by the sampling clock 37 used to clock the analogue to digital converters 29, 31, 33 and 35 of the DRFMs 1 and 3. An estimate of the phase difference between the input signals $X_1$, $X_2$ is thus provided at the output of the divide circuit 49.

It will be appreciated that whilst sampling the input signals $X_1$, $X_2$ for large values of N will enable very accurate estimates of the phase differences to be obtained, an estimate of the phase difference may be obtained from a single sample, such that the estimate is available in real time.

It will be appreciated that the apparatus described is designed for very high speed operation. Only the simple operations of subtraction, addition and delay takes place at the sampling clock rate, the division operation only being necessary each time the phase difference estimate is updated, which may be at any desired sub-multiple of the sampling clock rate.

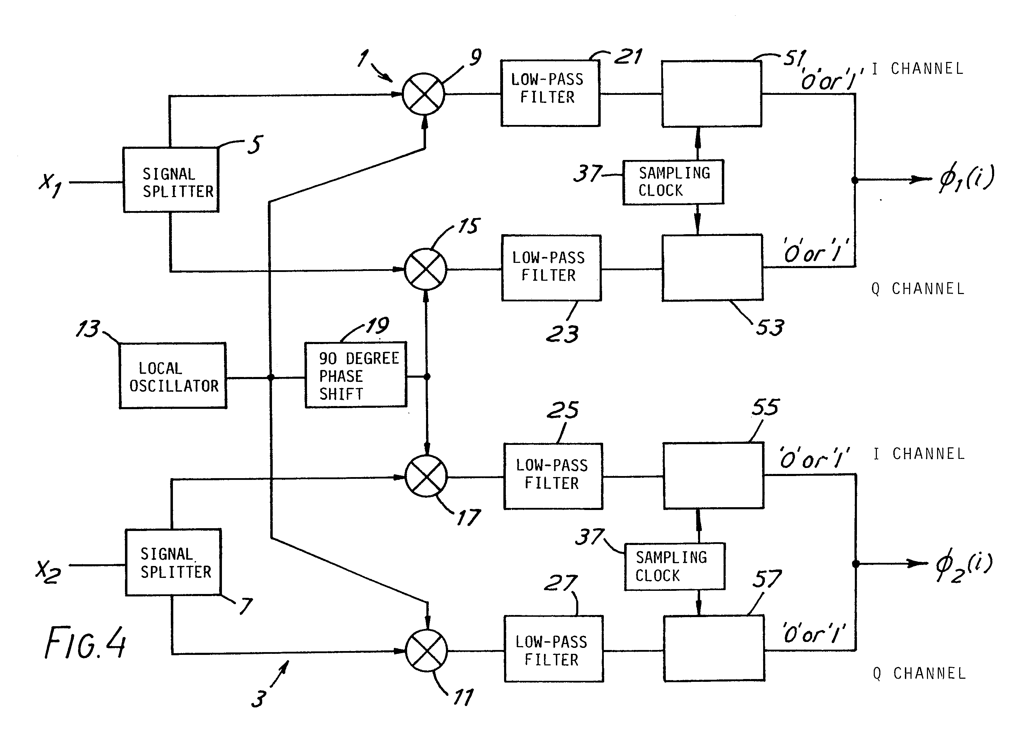

The apparatus described herebefore has been designed to give the capability of high accuracy measurements. To enable even higher speed operation however it may be expedient to replace the converters 29,31,35,37 and look up tables 39, 41 by four comparators, 51,53,55,57 one in respect of each channel of the two DRFMs 1,3 as shown in Figure 4. The comparators 51,53,55,57 are arranged to detect the polarity of their input signal, and give a 1 or 0 output as a result. The DRFMs 1, 3 are then only capable of distinguishing the four phase states representing the four I-Q quadrants in the graphical representation of Figure 2, with all amplitude information being lost. However the dynamic range of such a system is in principle, infinite. It has been found that using an apparatus of this type, with a local oscillator frequency of 3 GHz, a sampling rate of 1 GHz, and a sampling time of 1.024 microseconds, the phase difference between two copies of a microsecond pulse in the frequency range 2.5 GHz to 3.5 GHz may be measured with an r.m.s. error of 1.6 degrees. If these signals were from a two element array with a half wavelength separation an on-axis directional accuracy of approximately 0.5 degrees may be achieved in the determination of the angle of arrival of an incoming microwave signal.

It will be appreciated that whilst the apparatus described herebefore is designed to determine the phase difference between a pair of incoming signals, apparatus in accordance with the invention may be designed in which an array of three or more quadrature sampling systems, all operating from a common local oscillator, enable the phase differences between pairs of signals arriving at a selection from corresponding array of three or more array elements.

It will also be appreciated that whilst the invention finds particular application in the measurement of phase difference between pairs of RF and microwave signals received by an array, methods and apparatus in accordance with the invention may also be used in other situations where it is required to determine the phase difference between two signals of equal frequency.

## Claims

1. A method for measuring the phase difference between a plurality of signals of equal frequency, the method comprising quadrature sampling the signals using a plurality of quadrature sampling circuits having a common local oscillator so as to provide values of instantaneous phase in respect of each signal, deriving from the values of instantaneous phase a plurality of values of phase difference between at least a first and a further of the signals, and obtaining the mean value of the plurality of values of phase difference.

2. A method according to claim 1, wherein the plurality of values of phase difference are derived using modular arithmetic.

3. A method according to claim 1 or claim 2, comprising digitising the in phase and quadrature samples provided by the quadrature sampling of the signals and using the digitised values produced thereby in a look up table to provide the values of instantaneous phase.

4. A method according to claim 1 or claim 2, comprising affording the in phase and quadrature samples provided by the quadrature sampling of the signals to comparator means arranged to detect the polarity of the signals afforded thereto thereby to provide a binary value indicative of the instantaneous phase of the in phase and quadrature samples.

5. A method according to any one of the preceding claims, wherein the mean value of the plurality of values of phase difference is obtained by accumulating the plurality of values of phase difference, thereby to provide accumulated values, and dividing the accumulated values using a divider arranged to receive an input signal derived from a clock signal used to effect the quadrature sampling of the input signal.

6. A method according to any one of the preceding claims, wherein the mean value of the plurality of values of phase difference is obtained at a sub-multiple of the rate of quadrature sampling of the signals by the quadrature sampling circuits.

7. Apparatus for measuring the phase difference between at least two signals of equal frequency, the apparatus comprising a plurality of quadrature sampling circuits having a common local oscillator for providing from signals input thereto values of instantaneous phase in respect of each input signal, and an arithmetic circuit for deriving from the values of instantaneous phase a plurality of phase difference values between at least a first and a further of the input signals, and an averaging circuit for obtaining the mean value of the plurality of phase difference values.

8. Apparatus according to claim 7, wherein the arithmetic circuit is arranged to function using modular arithmetic.

9. Apparatus according to claim 7 or claim 8, wherein the averaging circuit comprises an accumulator for providing an accumulated sum of the plurality of values of phase difference and a divider circuit having a first input for receiving the accumulated sum and a further input for receiving a clock signal derived from a clock signal used to clock the quadrature sampling circuits.

10.. Apparatus according to any one of claims 7 to 9, wherein the averaging circuit is arranged to provide the mean value at a sub multiple of the rate at which the input signals are quadrature sampled by the quadrature sampling circuits.

11. Apparatus according to any one of claims 7 to 10, wherein the quadrature sampling circuits comprise digital radio frequency memories.

12. Apparatus according to any one of claims 7 to 11, wherein the quadrature sampling circuits include analogue to digital converters for providing digitised quadrature samples of the input signals and a look up table for providing the values of instantaneous phase from the digitised quadrature samples.

13. Apparatus according to any one of claims 7 to 11, wherein the quadrature sampling circuits comprise comparator means arranged to detect the polarity of quadrature sampled signals afforded thereto and to provide a binary value indicative of the phase of the quadrature sampled signals.

14. A phased array radar system comprising apparatus for measuring the phase difference between at least two signals of equal frequency according to any one of claims 7 to 13.

FIG.1

EP 0 379 321 A2

Q CHANNEL VALUE

$\phi_1(t)$

I CHANNEL VALUE

$\phi_2(t)$

*FIG.2*

47

UNIT DELAY

$\phi_1(i)$

MODULAR SUBTRACT

ADDER

43

45

49

DIVIDE

PHASE DIFFERENCE ESTIMATE

$\phi_2(i)$

SAMPLING CLOCK

COUNTER

37

51

*FIG.3*

FIG.4.